# EUROPEAN PATENT APPLICATION

(11) **EP 3 035 385 A1**
(43) Date of publication of application: **22.06.2016**
(21) Application number: 15189746.9
(22) Date of filing: 14.10.2015
(51) Int. Cl.: H01L 23/498, H01L 25/065, H01L 29/872

(54) **SEMICONDUCTOR INTERPOSER COMPRISING A SCHOTTKY DIODE AND A METHOD FOR FABRICATING THE INTERPOSER**

(30) Priority: 16.12.2014 EP 14198145
(71) Applicant: IMEC VZW, 3001 Leuven (BE); Taiwan Semiconductor Manufacturing Co., Ltd., 300-077 HsinChu (TW)
(72) Inventor: Hellings, Geert, 3001 Leuven (BE); Linten, Dimitri, 3001 Leuven (BE); Lee, Jam-Wem, 300-077 HsinChu (TW)
(74) Representative: Patent Department IMEC

(57) **Abstract**

An interposer (1) is disclosed which comprises a semiconductor substrate (2) comprising a through-substrate-via (3), and a junction metal (4) electrically contacting the through-substrate-via (3). The junction metal (4) contacts a doped region (5) at a main surface (6) of the semiconductor substrate (2) thereby realizing a Schottky diode (7). Further an electronic device is disclosed comprising the interposer. Also disclosed are the use of the interposer as a protection device by providing a discharge path through the Schottky diode (7) to the semiconductor substrate (2) and a method for fabricating an interposer comprising in a semiconductor substrate (2) a Schottky diode (7).

## Description

### Field

The present disclosure is related to semiconductor interposers suitable for assembly of integrated circuits in semiconductor packages or other semiconductor assemblies, wherein the semiconductor interposer comprises a Schottky diode that provides a discharge path during fabrication of the interposer, the fabrication of the semiconductor package or semiconductor assemblies and when in use.

### State of the art

In US6617681 B1 an interposer is disclosed as a structure suitable for connecting an integrated circuit to a supporting substrate wherein the structure has thermal expansion characteristics well-matched to the integrated circuit. The integrated circuit and the interposer are comprised of bodies that have substantially similar coefficients of thermal expansion. The interposer has a first surface adapted to electrically and mechanically couple the interposer to the integrated circuit. The interposer has a second surface adapted to electrically and mechanically couple the interposer to a supporting substrate. Electrically conductive vias in the interposer provide signal pathways between the first surface and the second surface of the interposer. The application discloses that various circuit elements may be incorporated into the interposer. These circuit elements may be active, passive, or a combination of active and passive elements. The application further discloses that by integrating various active and passive circuit elements into the interposer, it is possible to include circuit functionality into the interposer.

US 6617681 B1 further discloses that active devices include transistors integrated into the interposer. Transistors are insulated gate field effect transistors (FETs) and include source/drain terminals, gate electrodes, and gate dielectrics. Transistors may be n-channel FETs or p-channel FETs.

It will be appreciated by the skilled person in the art that the integration of additional circuit functionality into the interposer, for instance a FET comes at a cost. The additional process steps needed to achieve the additional circuit functionality include but are not limited to: patterning, doping, annealing. Multiple of these process steps are required and add cost and complexity to the method for fabrication the devices.

There is a need to achieve low cost and less complex methods to add additional circuit functionality and components into the interposer, these components when in use will offer additional functionality at reduced cost.

### Summary

It is an aim of the present disclosure to provide an additional component to an interposer at reduced fabrication complexity and cost. The component provides additional functionality to the interposer, during fabrication and when in use.

It is an advantage of embodiments of the present disclosure that the additional component acts as a protection device and can provide a discharge path to protect other components or structures in the interposer during fabrication of the interposer and when in use as an interposer.

It is an advantage of embodiments of the present disclosure that the additional component act as a protection device that may provide a discharge path to protect components assembled or otherwise electrically connected to the additional component of the interposer, during the assembly fabrication and when in use as an assembly containing the interposer.

It is an advantage of the embodiments of the present disclosure that limited additional complexity or process steps need to be added to define the additional component.

In a first aspect the disclosure is related to an interposer comprising: a semiconductor substrate comprising at a main surface a through-substrate-via at least partially extending through the substrate and; a junction metal electrically connected to the through-substrate-via;
characterized in that: the junction metal contacts a doped region at the main surface of the semiconductor substrate thereby realizing a Schottky diode.

It is an advantage of the embodiments a Schottky diode is integrated into the interposer whereby, the Schottky diode is connected to the through-substrate-via.

According to an embodiment the doped region extends over substantially the whole of the main surface of the semiconductor substrate.

It is an advantage of some embodiments of the present disclosure that multiple Schottky diodes can be connected to a common node, for example a single anode.

It is an advantage of some embodiments of the present disclosure that no additional doping steps are required to form the Schottky diode.

It is an advantage of some embodiments that no additional gate oxide is required to form the Schottky diode.

According to an embodiment the through-substrate-via and the doped region are adjacent and are connected through a layer of the junction metal, the junction metal layer is formed on the main surface.

It is an advantage of some embodiments of the present disclosure that small footprint structures can be made, that have the Schottky diode adjacent to the TSV, to enable high density and narrow pitch the TSV's.

According to an embodiment the interposer has a damascene metallization level on the semiconductor substrate, the damascene metallization level is connected to the through-substrate-via and to the junction metal.

It is an advantage of some embodiments that the damascene metallization level can be deposited directly on the junction metal of the Schottky diode, realizing an electrical contact to the Schottky diode.

According to an embodiment the junction metal is part of the barrier layer of the damascene metallization level.

It is an advantage of some embodiments that the barrier layer, of the damascene metallization level, is used as a junction metal to define the Schottky diode. The junction metal is formed during the formation of the metallization level.

In a second aspect the disclosure is related to an electronic device comprising an interposer according to the first aspect of the disclosure.

In a third aspect the disclosure is related to the use of an interposer, according to the first aspect of the disclosure, as a protection device by providing a discharge path through the Schottky diode to the semiconductor substrate.

According to an embodiment of the disclosure the semiconductor substrate of the interposer, when in use, is connected to a ground potential.

In a fourth aspect the disclosure is related to a method for fabricating an interposer comprising in a semiconductor substrate a Schottky diode, the method comprising: providing a semiconductor substrate comprising a doped region at a main surface; providing at the main surface a through-substrate-via at least partially extending through the semiconductor substrate; forming a junction metal in contact with the doped region thereby realizing a Schottky diode and; forming an electrical connection between the through-substrate-via and the Schottky diode.

It is an advantage of some embodiments of the method that a minimum of process steps is required to provide the additional functionality.

### Brief description of the figures

FIG 1 illustrates a cross sectional view of the interposer according to embodiments of the disclosure.

FIG 2 illustrates a cross sectional view of the interposer according to embodiments of the disclosure.

FIG 3 illustrates a cross sectional view of the interposer according to embodiments of the disclosure.

FIG 4 illustrates a cross sectional view of the interposer according to embodiments of the disclosure.

### Detailed description

The present disclosure will be described with respect to particular embodiments and with reference to certain drawings but the disclosure is not limited thereto. The drawings described are only schematic and are non-limiting. In the drawings, the size of some of the elements may be exaggerated and not drawn on scale for illustrative purposes. The dimensions and the relative dimensions do not correspond to actual reductions to practice of the disclosure.

Furthermore, the terms first, second and the like in the description, are used for distinguishing between similar elements and not necessarily for describing a sequence, either temporally, spatially, in ranking or in any other manner. It is to be understood that the terms so used are interchangeable under appropriate circumstances and that the embodiments of the disclosure described herein are capable of operation in other sequences than described or illustrated herein.

Moreover, the terms top, under and the like in the description are used for descriptive purposes and not necessarily for describing relative positions. It is to be understood that the terms so used are interchangeable under appropriate circumstances and that the embodiments of the disclosure described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

The current disclosure relates to an interposer suitable for semiconductor packaging or other semiconductor assemblies like but not limited to; 2.5D and 3D integration, system in a package (SIP), multi-chip modules (MCM). The interposer has additional functionality at minimum cost and minimum added process steps.

In a first aspect, the disclosure relates to an interposer **1** comprising a semiconductor substrate **2** comprising at a main surface **6** a through-substrate-via **3,** at least partially extending through the substrate **2,** and a junction metal **4** electrically connected to the through-substrate-via **3,** characterized in that the junction metal **4** contacts a doped region **5** at the main surface **6** of the semiconductor substrate **2** thereby realizing a Schottky diode **7.**

The semiconductor substrate **2,** for instance a silicon substrate, is suitable for use in planar semiconductor integration technologies. Other semiconductor materials or compound semiconductor materials can be used as substrate material. The semiconductor substrate **2** has a doped region **5** at the main surface **6.** The semiconductor substrate **2** may further comprise a well region (not shown) containing the doped region **5.**

Preferably, the doped region **5,** the substrate **2,** and if present the well region, have the same doping type thereby creating a discharge path from the doped region **5** towards the substrate **2.**

The doped region **5** can be a p-type doped region. The p-type doped region can be located in a p-type doped semiconductor substrate **2.** The p-type doped region can be embedded in a p-type or n-type doped well region, located in a p-type doped semiconductor substrate. The p-type doped region can be the semiconductor substrate. The p-type doped region can be a well region located in a p-type semiconductor substrate.

The doping concentration of the doped region **5** may be higher than the doping concentration of the well, which in turn may be higher than the doping concentration of semiconductor substrate **2.**

The doped region **5** can extend over the whole semiconductor substrate **2** thereby forming a substrate with a similar doping at the main surface 6.

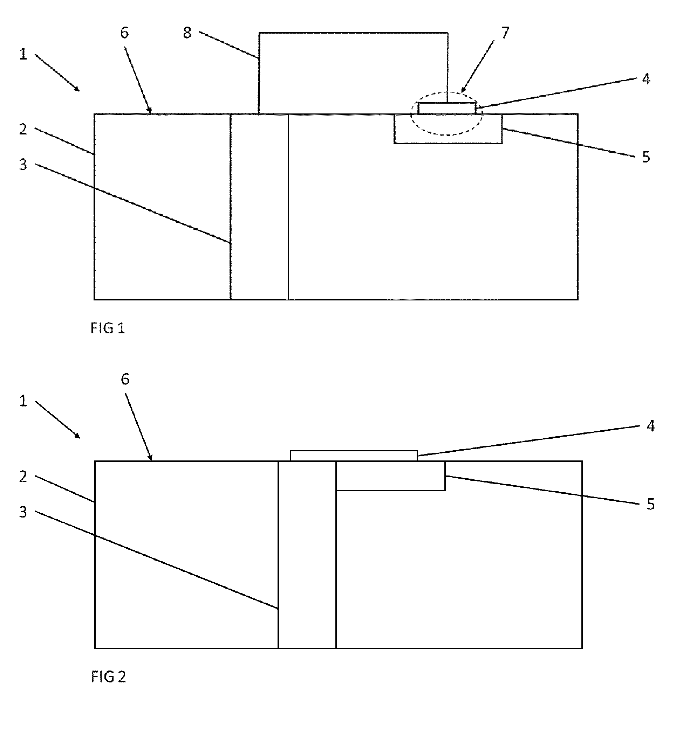

As illustrated in FIG 1, a through-substrate-via 3 (TSV) is provided at a main surface **6** of the semiconductor substrate **2,** whereby the TSV extends through the whole of the semiconductor substrate **2.** In some embodiments the TSV partially extends in the substrate **2,** whereby the non-extended part of the semiconductor substrate **2,** i.e. the part of the substrate **2** underneath the partially extended TSV, is used as additional mechanical support. For example: if the interposer **1** is used as an intermediate product, then the TSV only extends into a part of the semiconductor substrate **2** and it has all it surfaces, i.e. sidewall and a bottom, touching the substrate **2.** In some embodiments the TSV extends fully through the semiconductor substrate **2** from one main surface to another main surface, in which case the TSV has a sidewall and has openings at the opposite main surface of the substrate **2.**

At the main surface **6** of the semiconductor substrate an electrical connection **8** is formed between the TSV **3** and the junction metal **4.**

The junction metal **4** is in physical contact with the doped region **5.** The interface where the doped region **5** contacts the junction metal **4** is a semiconductor/metal interface and is adapted to form a Schottky diode **7.** The Schottky diode **7** consists of the doped region **5** contacted by the junction metal **4,** thereby forming a Schottky barrier. Schottky diodes are well known to the skilled person in the art; a selection of metals and associated doping levels of the doped region **5,** to obtain good quality Schottky diodes can be made and will not be explained in detail. A junction metal **4** compatible with current semiconductor manufacturing flow and equipment is, for example but not limited to, selected from the group of TaN, TiN, Al, Al(Cu), Mn, Ni, Ti.

According to an embodiment, the doped region **5** extends over substantially the whole of the main surface **6** of the semiconductor substrate **2.** The regions of the main surface **6** where the TSV is provided remain undoped. The TSV extends through the doped region **5** in the semiconductor substrate **2.** This embodiment enables multiple Schottky diodes to share a common node, the common node being connected through the doped region **5,** for instance a common anode when the doped region **5** is p-type doped. No additional doping, other than the doped region **5** already present in the substrate **2,** is needed to form multiple diodes sharing a common node. This makes the interposer **1** cost efficient as it doesn't not require the use of front end of line (FEOL) tools to process the interposer thereby completing the discharge path.

FIG 2 illustrates an embodiment wherein the TSV **3** is adjacent to the doped region **5.** The doped region **5** is formed at a main surface **6** of the semiconductor substrate **2.** A layer formed of junction metal **4** is in contact with the main surface **6** and overlaps both the doped region **5** and the TSV **3.** The junction metal **4** connects the TSV **3** with the Schottky diode.

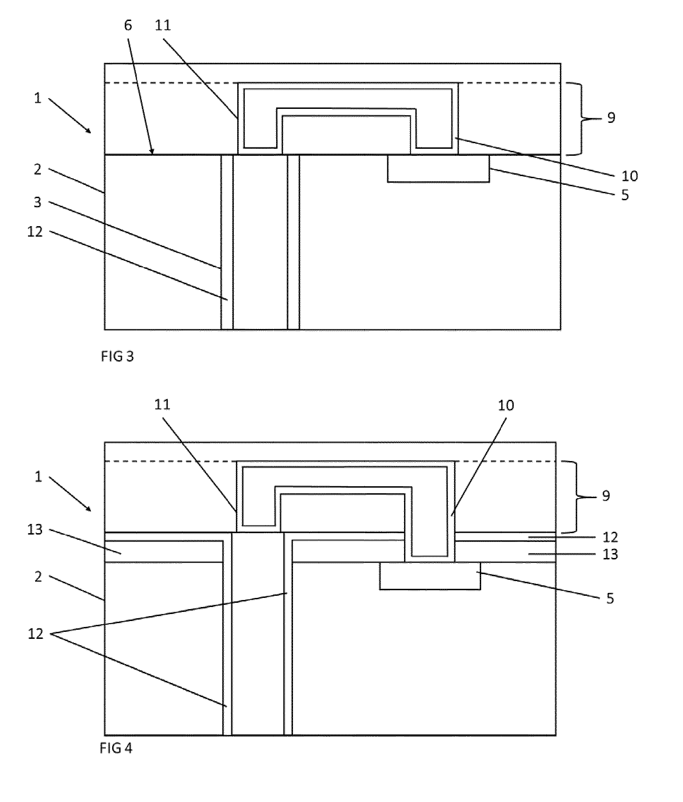

As illustrated in FIG 3, the interposer **1** may comprise a liner **12** on the surfaces of the TSV **3;** TSV sidewalls, and if present on the bottom of the TSV **3,** whereby the upper surface of the liner **12** is aligned with the upper surface of the through-substrate-via **3.** The liner **12** electrically isolates the TSV from the substrate **2.** The liner **12** is deposited on all the TSV inner surfaces. As the liner **12** is formed within the TSV hole, the liner **12** is not present on the upper surface of the TSV. The liner **12** can be present on the main surface **6** and is then in contact with the doped region **5.** The liner **12** is aligned with the upper surface of the TSV after the overburden of conductive material of the TSV is removed, for example by chemical mechanical polishing (CMP).

According to an embodiment of the current disclosure, the interposer **1** can further comprise a damascene metallization level **9** which is present on the semiconductor substrate **2.** The damascene metallization level **9** is connected to the through-substrate-via (TSV) **3** and to the junction metal **4,** thereby electrically connecting the junction metal **4** and the TSV conductive material as illustrated in FIG 3. This metallization level **9** can be single damascene or dual damascene. Both are techniques well known in the art to provide an interconnect in a back end of line (BEOL) process. The damascene integration provides an inter metal dielectric (IMD) with a first via Vial and a first metal Metall interconnections. It will be understood that multiple metallization levels may be used in the interposer **1,** however for simplicity only a single metallization level is shown. The metallization level **9** is fabricated with BEOL tools which can be contaminated by the metal used to form the electrical connections inside the metallization level **9,** for example copper or a copper alloy. These BEOL tools cannot be used if FEOL processing is to be done, as Cu contained in the tool could degrade the performance of the FEOL devices, by diffusing Cu into the FEOL devices. It is an advantage of the current disclosure that no FEOL tools are required to complete the formation of the Schottky diode, enabling a BEOL only toolset to be used to fabricate the additional functionality provided by the interposer. As the semiconductor substrate **2** is already provided with a doped region **5,** all subsequent steps to complete the Schottky Diode **7** are possible by the use of BEOL tools, i.e. providing a TSV, forming junction metal **4,** forming an electrical connection **8.**

According to an embodiment of the current disclosure, the barrier layer **10** of the damascene metallization level is used as the junction metal **4.** This further simplifies the flow as no separate junction metal **4** needs to be deposited. A barrier layer **10** is routinely formed in the damascene technology to prevent the metal, used to form the connections inside the metallization level **9,** for example copper, to diffuse into; the substrate, into IMD or into any other surrounding materials where the metal could diffuse into. Using the barrier layer **10** as a junction metal **4,** further reduces the costs and complexity by reducing the number of process steps. In order to accommodate existing barrier layer materials like TaN or TiN, the doping level of the doped region **5** needs to be adapted such that a Schottky barrier is formed at the semiconductor/junction metal interface thereby realizing the Schottky diode 7. The metallization **11** comprises, the metal that is used for the connection, in the metallization level **9.** The barrier layer **10** is conductive and also part of the metallization **11.**

The interposer **1** may further comprise a dielectric layer **13** interposed between the semiconductor substrate **2** and the metallization level **9.** The metallization **11** extends through this dielectric layer **13** to the doped region **5.** In case a liner **12** is present on the doped region **5,** as disclosed in foregoing paragraphs, the metallization **11** also extends through the liner **12** to the doped region **5.** The liner **12** can be formed on top of the dielectric layer **13.** Alternatively, the liner **12** can be in between the dielectric layer **13** and above the doped region **5.** The dielectric layer **13** can for example be deposited silicon oxide.

The metallization **11** may extend through the dielectric layer **13** to contact the TSV. Alternatively, as illustrated in FIG 4, the TSV may extend through the dielectric layer **13** to contact the metallization **11,** if the liner **12** is present, it is then on top of and in contact with the dielectric layer **13.** Either the TSV or the metallisation **11** extends through the dielectric layer 13 to create an electrical contact between the filled TSV and the metallisation **11.**

The dielectric layer **13** may be used as an anti-stress layer to avoid for example warpage of the interposer **1.**

In embodiments wherein the metallization level **9** does not fully cover the TSV conductive material, at the TSV upper surface, underlying layers might be contaminated by the metal of the metallisation level **9.** To prevent this metal contamination of the semiconductor substrate **2,** liner **12** or dielectric layer **13,** an additional barrier layer may be advantageously applied between the upper surface of the TSV and the metallization level **9.**

In a second aspect the disclosure relates to an electronic device comprising an interposer device **1** according to the first aspect of the disclosure. The electronic device comprising the interposer **1** can be a semiconductor package or other semiconductor assembly like but not limited to 2.5D and 3D integration, system in a package (SIP), or multi-chip modules (MCM).

In a third aspect the disclosure relates to the use of an interposer, according to the first aspect of the disclosure, as a protection device by providing a discharge path through the Schottky diode **7** to the semiconductor substrate **2.** The Schottky diode **7** may advantageously be used to discharge, charge present on the connection **8,** between the junction metal **4** and the TSV **3.** Electrical charge present on the connection **8** between the TSV and the reverse biased Schottky diode 7 will be drained by the reverse bias leakage current of the Schottky diode **7.** By removing this electrical charge from the connection **8,** a device connected to connection 8 may be protected against overcharging. The reverse breakdown voltage of the Schottky diode **7** is advantageously above the normal operating supply voltage so that the Schottky diode **7** will not interfere with normal operation of; the interposer **1** when in use and with the components connected to the connection **8.** Electrical charge on the connection **8** can for example come from charging during plasma etching of the damascene metallization level **9.** The path of the leakage current or discharge path, is through the metal connection through the junction metal **4** to the doped region **5** and from there may go to the semiconductor substrate **2.** The doped region **5** advantageously has a low electrical resistance to the semiconductor substrate **2.** This may be accomplished by having an identical doping type between doped region **5** and semiconductor substrate **2,** optionally the same doping for the well region, and by defining the respective doping levels for low resistivity.

According to an embodiment of the disclosure, the interposer when in use has the semiconductor substrate **2** connected to a low impedance potential point, for example a ground potential. In normal use the substrate when p-type doped, will be connected to a ground potential. The Schottky diode **7** is connected to the electrical connection **8** and provides a discharge by a reverse bias leakage current, of the Schottky diode **7,** to the grounded semiconductor substrate **2.** The Schottky diode **7** provides a discharge path to a ground potential and may provide as such a protection against the charging of the components connected to it.

In a fourth aspect the disclosure relates to a method for fabricating an interposer 1 according to the first aspect. The interposer **1** comprises a semiconductor substrate **2** having a Schottky diode **7.** The method comprises: providing a semiconductor substrate **2** comprising a doped region **5** at a main surface **6;** providing at the main surface **6** a through-substrate-via **3** at least partially extending through the semiconductor substrate **2;** forming a junction metal **4** in contact with the doped region **5** thereby realizing a Schottky diode **7,** and; forming an electrical connection **8** between the through-substrate-via **3** and the Schottky diode **7.** The TSV is electrically connected to the junction metal **4** of the Schottky diode **7.**

The method may comprise providing a substrate **2** having a doped region **5** that extends over substantially the whole of the main surface **6** of the semiconductor substrate **2.**

Providing at the main surface **6** a TSV 3 may comprise: forming a TSV hole at least partially extending through the semiconductor substrate **2,** and; providing a conformal liner **12** covering the main surface **6** of the semiconductor substrate **2** and the inner surfaces of the TSV hole, including the TSV sidewalls and the TSV bottom, when present. Optionally a barrier layer **10** and a seed layer may be deposited on the conformal liner **12.** Thereafter the TSV hole is complete filled with conductive material. Any overburden of this conductive material is removed, thereby exposing the liner **12** at the main surface. The conductive material **7** of the through-substrate-via **3** may be copper or a copper alloy.

By removing the excess conductive material, the upper surface of the liner **12** is aligned with the upper surface of the TSV while the liner **12** remains present on the sidewalls or sidewall and at the bottom of the TSV, if present.

When removing the excess conductive material, optionally the liner **12** is also removed from the main surface whereby the main surface of the semiconductor substrate **2** is exposed. The main surface **6** of the semiconductor substrate **2** is then aligned with the upper surface of the TSV whereby the liner **12** remains present on the sidewalls and on the bottom of the TSV, if present.

Forming the electrical connection **8** may comprise forming a damascene metallization level **9** on the semiconductor substrate **2,** thereby electrically connecting the TSV **3** to the junction metal **4** of the Schottky diode **7.**

The junction metal **4** can be formed while forming the damascene metallization level 9. In particular this can be done by the deposition of the barrier layer **10** in the damascene metallization level **9,** the barrier layer **10** is used a junction metal **4.** Then the Schottky diode **7** is formed at the same time when the barrier material **10** of the damascene metallization level **9** is deposited.

The method may further comprise forming a dielectric layer **13** interposed between the semiconductor substrate **2** and the damascene metallization level **9.** When the damascene metallization level **9** is formed, the metallization **11** extends through the dielectric layer **13** and through the liner **12,** if present, to the doped region **5.** The metallization **11** refers to the actual metal connections used to form the electrical connections inside the metallization level **9** and may include a first metal layer METAL1 and a first via level VIA1 for a damascene metallization level **9.**

When forming the damascene metallization level **9,** the metallization **11** may extend through the dielectric layer to contact the TSV **3.**

Instead of having the metallisation **11** extending through the dielectric **13.** Forming the TSV may include providing an TSV that extends through the dielectric layer **13** towards the metallisation **11.** If the liner **12** is present, it will be interposed between the damascene metallization level **9** and the dielectric layer **13** whereby the upper surface of the liner **12** is aligned with the upper surface of the TSV in a single plane, i.e. the liner **12** and the TSV extend to the main surface **6.** In case the liner **12** is not present, the upper surface of the TSV is aligned with the upper surface of the dielectric layer.

Forming the junction metal **4** comprises providing an opening in the liner **12** and in the dielectric layer **13,** if present, to contact the doped region 5 at the location where the Schottky diode **7** will be formed. This opening may be formed in an additional step or may be formed while forming openings such as vias or trenches of the damascene metallization. The opening exposes the doped region **5** at the main surface **6** of the semiconductor substrate **2.**

Forming the junction metal **4** may comprise depositing a material that is not used as a barrier layer in the damascene metallization level **9.** This deposition may need an additional step to form this junction metal **4** in the opening provided to expose the doped region **5** and at the location the Schottky diode **7** is to be realized.

The semiconductor substrate **2** can be reduced in thickness, or thinned, by removing material from the side opposite the main surface of the semiconductor substrate **2** where the Schottky diode **7** is present. By thinning the substrate the conductive material of the TSV is exposed, such that the TSV extends through the thinned semiconductor substrate. This thinning step can be for example grinding or chemical mechanical polishing (CMP).

### Examples

In the following an example will be given of an embodiment according to the present disclosure. The values are given by way of example and are not limiting the scope of the present disclosure.
The semiconductor substrate **2** is a silicon p-type wafer with a background doping 4e15cm-3, the well region is p-type doped to 1e17cm-3, the well region is used as doped region **5,** and the junction metal **4** is Titanium. A Schottky diode is formed between the junction metal 4 and the p-type doped region.

## Claims

1. An interposer (1) comprising:
- a semiconductor substrate (2) comprising at a main surface (6) a through-substrate-via (3) at least partially extending through the substrate and;
- a junction metal (4) electrically connected to the through-substrate-via (3); **characterized in that**:
- the junction metal (4) contacts a doped region (5) at the main surface (6) of the semiconductor substrate (2) thereby realizing a Schottky diode (7).

2. The interposer according to claim 1 wherein the doped region (5) extends over substantially the whole of the main surface (6) of the semiconductor substrate (2).

3. The interposer according to any of the preceding claims wherein the through-substrate-via (3) and the doped region (5) are adjacent and are connected through a layer of the junction metal (4), the junction metal layer formed on the main surface (6).

4. The interposer according to any of the preceding claims wherein a damascene metallization level (7) is present on the semiconductor substrate (2), the damascene metallization level connected to the through-substrate-via and the junction metal (4).

5. The interposer according to claim 4 wherein the junction metal (4) is part of the barrier layer of the damascene metallization level (7).

6. An electronic device comprising an interposer according to any of the foregoing claims.

7. Use of the interposer according to any of the claims 1 to 5 as a protection device by providing a discharge path through the Schottky diode (7) to the semiconductor substrate (2).

8. The interposer according to claim 7 wherein the semiconductor substrate (2), when in use, is connected to a ground potential.

9. A method for fabricating an interposer comprising a semiconductor substrate having a Schottky diode, the method comprising:
- providing a semiconductor substrate (2) comprising a doped region (5) at a main surface (6);
- providing at the main surface a through-substrate-via (3) at least partially extending through the semiconductor substrate;
- forming a junction metal in contact with the doped region thereby realizing a Schottky diode and;
- forming an electrical connection between the through-substrate-via and the Schottky diode.
